# FASCICULE DE BREVET EUROPEEN

(11) **EP 0 749 637 B1**
(45) Date de publication et mention de la délivrance du brevet: **27.05.1998**
(21) Numéro de dépôt: 95912285.4
(22) Date de dépôt: 08.03.1995
(51) Int. Cl.: H01L 39/24

(54) **PROCEDE DE PREPARATION D'UN MATERIAU SUPRACONDUCTEUR DU TYPE OXYDE MIXTE**
VERFAHREN ZUM HERSTELLEN SUPRALEITENDEN MATERIALS VOM GEMISCHTEM TYP
METHOD FOR THE PREPARATION OF A MIXED OXIDE TYPE SUPERCONDUCTING MATERIAL

(30) Priorité: 09.03.1994 FR 9402710
(43) Date de publication de la demande: 27.12.1996
(73) Titulaire: COMMISSARIAT A L'ENERGIE ATOMIQUE, 75015 Paris (FR); ELECTRICITE DE FRANCE, 75008 Paris (FR)
(72) Inventeur: GENDRE, Philippe, F-92000 Nanterre (FR); REGNIER, Pierre, F-91440 Bures-sur-Yvette (FR); SCHMIRGELD-MIGNOT, Lélia, F-91120 Palaison (FR); MARQUET, André, F-75015 Paris (FR)
(74) Mandataire: Dubois-Chabert, Guy
(86) Numéro de dépôt international: FR9500262
(87) Numéro de publication internationale: WO9524739

(56) Documents cités:
- WO-A-89/10336
- US-A- 5 120 707
- US-A- 5 162 295

## Description

L'invention a pour objet un procédé de préparation d'un matériau supraconducteur du type oxyde mixte à haute température critique.

La supraconductivité est un phénomène qui se développe à des températures inférieures à la température critique d'un matériau, c'est-à-dire la température à partir de laquelle la résistance électrique de ce matériau devient égale à 0 et un diamagnétisme parfait est observé. Ce phénomène est très intéressant, car il permet le transport de courant à des températures inférieures à la température critique sans perte d'énergie.

Les premier matériaux supraconducteurs qui ont été découverts avaient des températures critiques très basses qui nécessitaient un refroidissement au moyen d'hélium liquide. En 1986, Bednorz et Müller ont découvert un nouveau supraconducteur de type oxyde qui présentait une température critique supérieure à 30K et ne nécessitait plus un refroidissement au moyen d'hélium liquide. D'autres oxydes mixtes supraconducteurs ont été trouvés ensuite, comme par exemple l'oxyde YBa₂Cu₃O₇₋ₓ dont la température critique est de l'ordre de 90K, ce qui évite de recourir à l'hélium liquide pour le refroidir.

Toutefois, pour la plupart des applications visées des supraconducteurs, il est nécessaire de préparer ces matériaux sous la forme, soit de couches déposées sur des substrats pour réaliser des films minces destinés à la microélectronique de quelques centimètres carrés de surface et d'une épaisseur inférieure au micromètre, soit de fils, de rubans ou d'autres conducteurs pour l'électrotechnique de forte puissance dont la longueur sera de plusieurs centaines, voire plusieurs milliers de mètres et l'épaisseur de quelques micromètres à quelques millimètres.

Pour la préparation de films minces, on peut utiliser les techniques classiques de dépôt sous vide de couches minces telles que l'ablation laser, la pulvérisation cathodique, radio-fréquence et autres, le dépôt en phase vapeur de composés organométalliques, etc. Avec ces techniques, on obtient des produits présentant une excellente qualité électrique et magnétique, mais l'utilisation de ces techniques pour la fabrication de rubans ou de produits de grande longueur est difficile à envisager en raison des contraintes qu'elle exige pour obtenir cette qualité. En effet, l'excellence des performances n'est atteinte que sur des substrats monocristallins dont il est très difficile d'envisager la production en grande longueur. De plus, dans toutes ces techniques, la vitesse de dépôt est généralement trop lente pour que l'on puisse produire à un coût acceptable des couches de quelques micromètres d'épaisseur sur des centaines de mètres. Enfin, de nombreux travaux ont montré que pour des épaisseurs supérieures au micromètre, les couches préparées perdent leur texture et par suite transportent des densités de courant plus faibles.

Aussi, pour la préparation de produits de grande longueur, on a envisagé d'employer des techniques de la métallurgie des poudres en partant de l'oxyde supraconducteur en poudre ou d'oxydes précurseurs pulvérulents pouvant être transformés en supraconducteur par traitement thermique, en remplissant un tube métallique de ces poudres et en le mettant ensuite sous la forme de fils ou de rubans par des opérations mécaniques telles que le filage, accompagnées ou non de recuits intermédiaires. Les composites obtenus sont finalement recuits pour réunir les grains supraconducteurs entre eux et augmenter autant que faire se peut la capacité de transport du courant du produit obtenu. Ce procédé présente toutefois certains inconvénients qui sont :
1°/ de nécessiter un grand nombre d'opérations,
2°/ de nécessiter une optimisation pour que la section de l'oxyde supraconducteur reste constante sur toute la longueur du fil, car une seule striction suffit pour réduire à zéro la supraconductivité de l'ensemble, et
3°/ de retenir dans la gaine métallique des gaz qui nuisent à la qualité du produit.

On connaît encore un procédé de préparation de produits de grande longueur qui fait appel aux techniques de dépôt de couches métalliques par des procédés électrolytiques comme il est décrit dans US-A-5 162 295.

Selon ce document, on dépose sur un substrat conducteur des couches des métaux entrant dans la composition de l'oxyde mixte supraconducteur, puis on soumet l'ensemble des couches déposées à un traitement d'oxydation dans des conditions telles qu'on forme l'oxyde mixte supraconducteur. Cette technique présente toutefois l'inconvénient de conduire à des films supraconducteurs présentant une transition résistive beaucoup trop large et une densité de courant critique extrêmement faible.

La présente invention a précisément pour objet un procédé de préparation d'un matériau supraconducteur du type oxyde mixte, qui, bien qu'utilisant cette technique de dépôt électrolytique, conduit à des matériaux supraconducteurs présentant une transition résistive étroite et une densité de courant critique élevée.

Selon l'invention, le procédé de préparation d'un matériau supraconducteur du type oxyde mixte, l'oxyde mixte comportant p éléments métalliques, comprend les étapes suivantes :
a) déposer par électrolyse sur un substrat conducteur des couches successives des p éléments métalliques, chaque couche renfermant un seul élément et ayant une épaisseur telle qu'elle ne se détache pas du substrat ou de la couche précédemment déposée, et l'ordre des couches étant tel que les éléments susceptibles de réagir avec le substrat soient séparés de celui-ci par au moins une couche d'un autre élément, et effectuer, après le dépôt d'au moins l'une des couches, un traitement thermique intermédiaire d'oxydation-réaction pour fixer l'élément de cette couche avant de déposer la couche suivante,
b) répéter éventuellement une ou plusieurs fois au moins certaines opérations de dépôt électrolytique et de traitement thermique intermédiaire de l'étape a) pour obtenir l'épaisseur de matériau supraconducteur désirée, et
c) soumettre ensuite l'ensemble des couches à un traitement thermique final d'oxydation à une température suffisante pour former l'oxyde mixte supraconducteur.

Dans ce procédé, la réalisation d'au moins un traitement thermique intermédiaire d'oxydation-réaction, ainsi que l'ordre dans lequel on dépose les couches métalliques, permettent d'éviter qu'il se produise, lors du traitement thermique final, des réactions parasites avec le substrat. En effet, lors de l'oxydation finale des couches métalliques, divers liquides à bas point de fusion peuvent apparaître et réagir avec le substrat, et ceci est évité dans l'invention grâce au(x) traitement(s) thermique(s) intermédiaire(s) effectué(s) sur les éléments susceptibles de donner lieu à la formation de tels liquides. Par ailleurs, l'ordre des dépôts permet d'éloigner du substrat les éléments les plus réactifs avec celui-ci, notamment à la température du traitement thermique final. De plus, en limitant l'épaisseur des couches, on évite les phénomènes de desquamation qui nuisent à la qualité du produit. Ce phénomène s'observe généralement avec les couches de métaux alcalino-terreux qui, au-delà d'une épaisseur de 2 micromètres, ont tendance à se détacher du substrat.

Aussi, on limite généralement l'épaisseur des couches de métaux alcalino-terreux à moins de 2 µm.

De préférence, le procédé comprend de plus une étape préalable de traitement du substrat en vue de faciliter l'accrochage de la première couche déposée sur celui-ci et/ou d'améliorer l'homogénéité de cette première couche.

Ce traitement peut consister en une ou plusieurs opérations de nettoyage, dégraissage, décapage et recuit, par des techniques classiques qui améliorent l'homogénéité et/ou l'adhésion du premier dépôt. Ce traitement est choisi en fonction de la nature du substrat utilisé. Ainsi, pour les substrats métalliques, un traitement simple et efficace consiste à effectuer un dégraissage suivi d'un recuit à haute température, par exemple pendant 2 à 30 min. sous air à une température de 700 à 800°C dans le cas de l'argent.

Les substrats susceptibles d'être utilisés peuvent être constitués par divers matériaux conducteurs ou non conducteurs de l'électricité. Dans le cas où ils sont réalisés en matériau non conducteur, on dépose sur ceux-ci une couche conductrice, par exemple une couche d'argent par divers procédés, comme par exemple la pulvérisation cathodique, l'évaporation sous vide, le trempage chimique.... Par ailleurs, on choisit comme matériau de substrat un matériau ne donnant pas lieu, dans les conditions de dépôt et de traitement thermique mises en oeuvre, à des réactions parasites même partielles avec les éléments des couches déposées pour former le matériau supraconducteur.

A titre d'exemples de matériaux susceptibles d'être utilisés comme substrat, on peut citer les aciers inoxydables réfractaires.

L'emploi, comme substrat, de matériaux oxydables tels que le nickel ou certains alliages de nickel, revêtus ou non d'argent, peut être intéressant lorsqu'on veut isoler électriquement la couche supraconductrice.

En effet, avec de tels matériaux, lors du traitement thermique final, le substrat s'oxyde sur une épaisseur plus ou moins forte qui l'isole électriquement de la couche supraconductrice, ce qui est bénéfique pour des applications où une résistivité relativement grande à l'état normal est recherchée.

L'ordre dans lequel sont déposées les couches des différents éléments, est choisi dans le but de minimiser les interactions avec le substrat, mais aussi afin d'éviter les incompatibilités entre les bains successifs d'électrolyse et d'obtenir après le premier traitement d'oxydation-réaction intermédiaire une couche suffisamment conductrice pour permettre les dépôts suivants. Ainsi, le traitement thermique intermédiaire d'oxydation-réaction est effectué sur les couches d'éléments métalliques susceptibles de former sur le substrat avec les éléments des couches déposées précédemment des oxydes suffisamment conducteurs pour que l'on puisse effectuer le dépôt de la couche suivante.

Dans la réalisation de chaque couche, les quantités déposées ne sont pas arbitraires, mais fonction de l'épaisseur et de la composition finale désirée.

L'épaisseur de chaque couche est choisie en fonction de l'épaisseur critique de la couche qui se desquame le plus facilement. Lorsque cette épaisseur est choisie, on calcule les épaisseurs des couches suivantes de façon à ce qu'elles correspondent aux proportions stoechiométriques par rapport à la quantité d'atomes de la couche qui se desquame le plus facilement. Si nécessaire, on répète le dépôt des couches autant de fois qu'il est nécessaire pour obtenir l'épaisseur voulue de matériau supraconducteur. Habituellement, l'épaisseur totale des couches déposées est de 2 à 20 µm et l'épaisseur de chaque couche est de 0,5 à 2 µm.

On peut aussi prévoir que certains éléments seront déposés sous la forme de plusieurs couches alors que d'autres éléments ne seront déposés qu'en une seule couche. Dans ce cas, l'épaisseur de la couche unique devra correspondre à la stoechiométrie par rapport à la quantité totale de l'élément déposé en plusieurs couches.

Ainsi, le procédé de l'invention peut être mis en oeuvre avec une grande souplesse, car il n'est pas nécessaire que l'épaisseur de couche de chaque élément métallique corresponde à la stoechiométrie par rapport aux autres couches.

Selon l'invention, on effectue un traitement thermique intermédiaire d'oxydation-réaction sur les couches des éléments les moins stables du point de vue mécanique et/ou chimique, voire les moins conductrices de l'électricité.

Ainsi, lorsque l'oxyde mixte comporte un ou plusieurs métaux alcalino-terreux, on effectue généralement un traitement thermique intermédiaire d'oxydation-réaction après le dépôt de chaque couche de métal alcalino-terreux pour fixer celui-ci tout en obtenant un mélange d'oxyde suffisamment conducteur pour que l'on puisse effectuer d'autres dépôts. Le procédé de l'invention est donc très intéressant, car en stabilisant ainsi certains éléments avant le traitement final, on évite les réactions parasites et on améliore les performances du matériau supraconducteur.

De plus, ce procédé peut être mis en oeuvre pour la préparation d'éléments de grande longueur, tels que des fils ou des rubans, en effectuant les opérations de dépôt et de traitement thermique au défilé en continu.

Par ailleurs, avec ce procédé, les opérations d'usinage final du produit obtenu en vue de le mettre sous sa forme définitive peuvent être réalisées avant ou après le traitement thermique final.

Ce procédé peut être également mis en oeuvre pour la réalisation d'éléments supraconducteurs comprenant des fibres tressées ou torsadées en utilisant plusieurs produits obtenus par ce procédé pour former des tresses, en les incluant dans une gaine appropriée et en transformant ensuite l'ensemble par des opérations thermomécaniques telles que le martelage, le laminage-tréfilage, en éléments supraconducteurs comportant des faisceaux de fibres supraconductrices.

Ce procédé peut aussi être utilisé pour réaliser des dépôts supraconducteurs directement sur des substrats de forme complexe, telles que des tresses, des torsades, des feutres ou des mousses.

Le procédé de l'invention peut être encore mis en oeuvre de façon à former sur le substrat des circuits supraconducteurs ayant un profil voulu, soit en déposant directement les métaux selon le tracé voulu, soit en usinant ensuite le substrat recouvert des couches déposées, par des procédés mécaniques, ioniques, photochimiques ou lithographiques pour éliminer les couches sur certaines zones du substrat, avant ou après l'étape c) de traitement thermique final.

On peut aussi avec ce procédé déposer en fin d'opération une ou plusieurs couches de substance destinée à la protection, à l'isolement, au renforcement, à l'amélioration des propriétés électriques et magnétiques, ou encore à la thermalisation du matériau supraconducteur. On peut aussi déposer une dernière couche métallique servant de substrat pour recommencer la séquence d'opérations conduisant au matériau supraconducteur en vue de réaliser des supraconducteurs multibrins

Une autre possibilité intéressante consiste à déposer en premier lieu une couche d'argent dans laquelle sont dispersés des atomes d'un autre métal plus oxydable de façon à former lors du traitement thermique final une gaine composite renforcée par une dispersion fine d'oxyde très dur.

Le procédé de l'invention est facile à mettre en oeuvre puisqu'il comprend essentiellement des étapes de dépôt par électrolyse et des traitements thermiques.

Les dépôts électrolytiques peuvent être réalisés par des techniques classiques en utilisant comme bain de dépôt électrolytique, une solution d'un sel de l'élément à déposer en particulier un chlorure ou un nitrate, dans un solvant approprié tel que l'eau, le diméthylsulfoxyde, l'acétonitrile ou les mélanges de ces deux derniers. Généralement, pour l'opération de dépôt, le substrat sert de cathode et il est associé à deux contre-électrodes, qui peuvent être des anodes solubles de même nature que le métal déposé ou bien des anodes insolubles en platine ou alliage de platine par exemple.

Les traitements thermiques intermédiaires ainsi que le traitement thermique final peuvent être effectués à l'air. Les températures et les durées de ces traitements sont choisies en fonction des éléments et du matériau supraconducteur à former. Pour le traitement final, on effectue généralement celui-ci en deux étapes avec éventuellement une étape intermédiaire de trempe ou de refroidissement.

Le procédé de l'invention s'applique à de nombreux oxydes mixtes supraconducteurs . A titre d'exemple de tels oxydes, on peut citer ceux du type Y-Ba-Cu-O, La-Ba-Cu-O et La-Sr-Cu-O, soit d'autres oxydes mixtes dérivant de ces derniers par substitution partielle ou totale de l'yttrium par un élément du groupe des terres rares, et du baryum par le strontium, le cuivre ne pouvant être remplacé par d'autres atomes qu'en très faible proportion.

D'autres exemples d'oxydes mixtes supraconducteurs sont ceux du type Bi-Sr-Ca-Cu-O et Tl-Ba-Ca-Cu-O, Hg-Ba-Ca-Cu-O, Ag-Ba-Ca-Cu-O et leurs dérivés substitués (une centaine de supraconducteurs à haute température sont actuellement connus).

D'autres caractéristiques et avantages de l'invention apparaîtront mieux à la lecture de la description qui suit d'exemples de réalisation donnés bien entendu à titre illustratif et non limitatif, en référence aux dessins annexés, sur lesquels :
- la figure 1 représente les variations de la résistivité de deux couches de Bi₂ Sr₂ CaCu₂O₈, obtenues conformément à l'invention en fonction de la température (en K),
- la figure 2 est un diagramme de diffraction X d'une des deux couches de la figure 1,
- la figure 3 illustre les variations de la résistivité d'une couche de YBaCuO obtenue conformément à l'invention en fonction de la température (en K), et
- la figure 4 est un diagramme de diffraction X de la couche de la figure 3.

### Exemple 1 : 1er mode de préparation d'un ruban de Bi₂Sr₂CaCu₂O₈.

On part d'un substrat constitué par un ruban d'argent laminé de 50 µm d'épaisseur, de 20 mm de large et de 35 mm de longueur. On soumet tout d'abord le substrat à un dégraissage au trichloroéthane, puis on le recuit sous air à 850°C pendant 15 min. Après cette étape préalable de traitement du substrat, on réalise le dépôt des couches de bismuth, strontium calcium et cuivre en opérant de la façon suivante.

Ayant observé par diffraction de rayons X et analyse thermogravimétrique que le bismuth fondait avant de s'oxyder complètement lors d'une montée en température sous air, et constatant que le bismuth liquide réagissait fortement avec le substrat d'argent, on en a conclu que ce métal ne devait pas être déposé directement sur le substrat, mais au contraire le plus loin possible. Par ailleurs, on a observé que le strontium et le calcium ne formaient pas des couches stables et qu'il était donc nécessaire, d'une part, de ne pas dépasser une épaisseur de 1,5 à 2 µm correspondant à 3.10⁸ atomes/cm² pour avoir un dépôt adhérent, et d'autre part, de les soumettre à un traitement thermique intermédiaire d'oxydation-réaction pour fixer ces éléments. De ce fait, on a réalisé successivement les étapes suivantes :
1°/ dépôt d'une couche de cuivre,
2°/ dépôt d'une couche de strontium,
3°/ traitement thermique intermédiaire d'oxydation-réaction des couches de strontium et de cuivre,
4°/ dépôt d'une couche de bismuth,
5°/ dépôt d'une couche de calcium,
6°/ traitement thermique intermédiaire d'oxydation-réaction de la couche de calcium,
7°/ répétition des étapes 2, 3, 4, 5 et 6 et
8°/ traitement thermique final.

Dans l'étape 1), l'épaisseur de la couche de cuivre correspond à la quantité totale de cuivre nécessaire, soit nε atomes de cuivre.

En revanche, dans les étapes 2) et 4), l'épaisseur de la couche correspond seulement à E atomes et dans l'étape 3), l'épaisseur de la couche correspond à ε/2 atomes de calcium. Il est donc nécessaire de répéter (n-1) fois les étapes 2), 3), 4) et 5) et (n-2) fois l'étape 6).

On décrit ci-après la réalisation de ces différentes étapes dans le cas où ε=2,5.10¹⁸ atomes/cm².

### 1°/ dépôt de la couche de cuivre

On dépose uniformément environ 5.10¹⁸ atomes de cuivre par cm² sur chaque face du ruban d'argent en utilisant comme bain d'électrolyse le mélange H₂O + H₂SO₄(0,5M) + CuSO₄, 5H₂O (0,25M à 0,5M), en disposant le substrat d'argent entre deux contre-électrodes de cuivre et en faisant passer un courant total de 180 mA. Après l'opération de dépôt, on élimine les dernières traces de solution, puis on soumet le ruban revêtu à un séchage à l'air.

### 2°/ dépôt de la couche de strontium

On dépose uniformément sur la couche précédente 2,5.10¹⁸ atomes de strontium par cm² en utilisant comme bain d'électrolyse une solution à 0,1 mole/l de chlorure de srontium dans un mélange de diméthylsulfoxyde (DMSO) et d'acétonitrile (AN) (1/6 en vol.), en disposant le ruban d'argent revêtu de cuivre entre deux contre-électrodes de platine et en faisant passer un courant total de 180 mA. Après dépôt, on élimine les dernières traces de solution.

### 3°/ traitement thermique intermédiaire

Ce traitement consiste à recuire le ruban revêtu des couches de cuivre et de strontium sous air à 850°C pendant 5 min., ce qui permet de stabiliser le dépôt de strontium.

### 4°/ dépôt d'une couche de bismuth

On dépose uniformément environ 2,5.10¹⁸ atomes de bismuth par cm² sur le ruban soumis au traitement thermique précédent, en utilisant un bain d'électrolyse constitué par une solution à 1 mole/l de nitrate de bismuth dans le DMSO, en plaçant le ruban entre deux contre-électrodes de platine et en faisant passer un courant total de 180 mA. Après dépôt, on élimine les dernières traces de solution.

### 5°/ dépôt de la couche de calcium

On dépose uniformément environ 1,25.10¹⁸ atomes de calcium/cm² sur le dépôt précédent, en utilisant un bain d'électrolyse constitué par une solution à 1 mole/l de chlorure de calcium dans le DMSO, en disposant le ruban revêtu entre deux contre-électrodes de platine et en faisant passer un courant total régulé à 180 mA. Après dépôt, on élimine les dernières traces de solution.

### 6°/ traitement thermique intermédiaire

Pour effectuer ce traitement, on soumet le ruban revêtu dans les étapes précédentes à un recuit sous air à 850°C pendant 2 minutes.

### 7°/ répétition du cycle d'étapes 2 à 5

### 8°/ traitement thermique final

Pour réaliser ce traitement thermique à l'air, on introduit le produit constitué par le substrat d'argent revêtu des différentes couches dans un four chauffé à 800°C et on augmente rapidement la température à une vitesse de 1000°C/h jusqu'à 850-860°C, on maintient cette température pendant 2 minutes, on effectue ensuite une trempe en refroidissant à une vitesse d'environ 1000°C/min. jusque vers 20°C, puis on réchauffe à une vitesse de 60°C/h jusqu'à une température de 800°C, on maintient cette température de 800°C pendant 60 heures, et on effectue enfin une trempe rapide à l'air jusqu'à l'ambiante.

On détermine alors la résistivité du matériau supraconducteur ainsi obtenu en fonction de la température (en K).

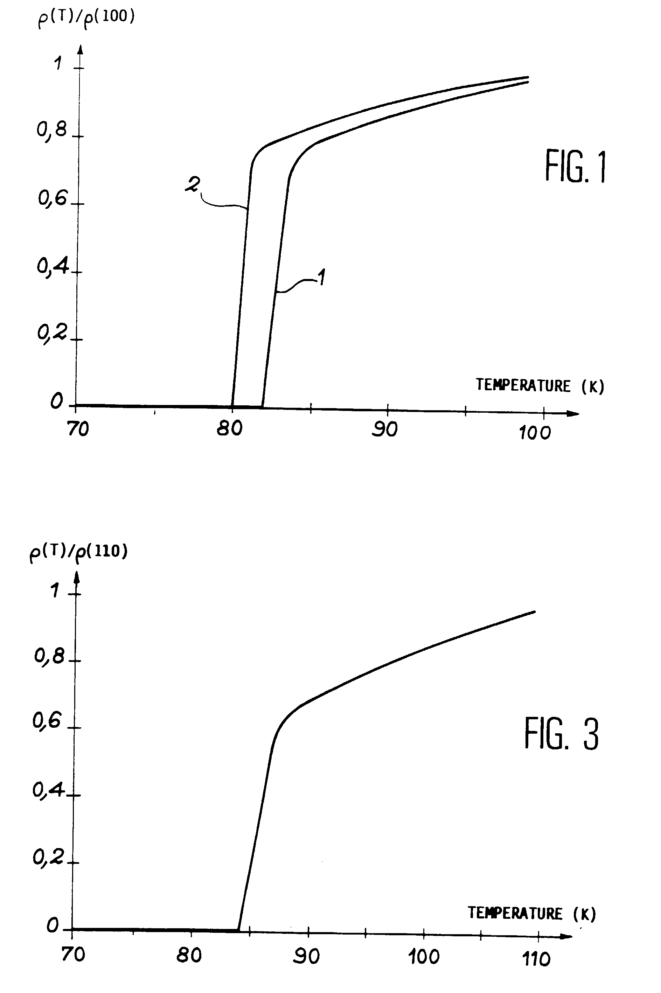

Les résultats obtenus sont donnés sur la figure 1 sur laquelle la courbe 1 représente les variations de la résistivité ρ exprimée en ρ(T)/ρ (100K), en fonction de la température (en K), sous une densité de courant de 500 A/cm².

Sur cette figure, courbe 1, on remarque que la transition supraconductrice est étroite et se situe à environ 82K. Par ailleurs, une mesure de la densité du courant critique à 77K indique qu'elle est de 10 000 à 15 000 A/cm².

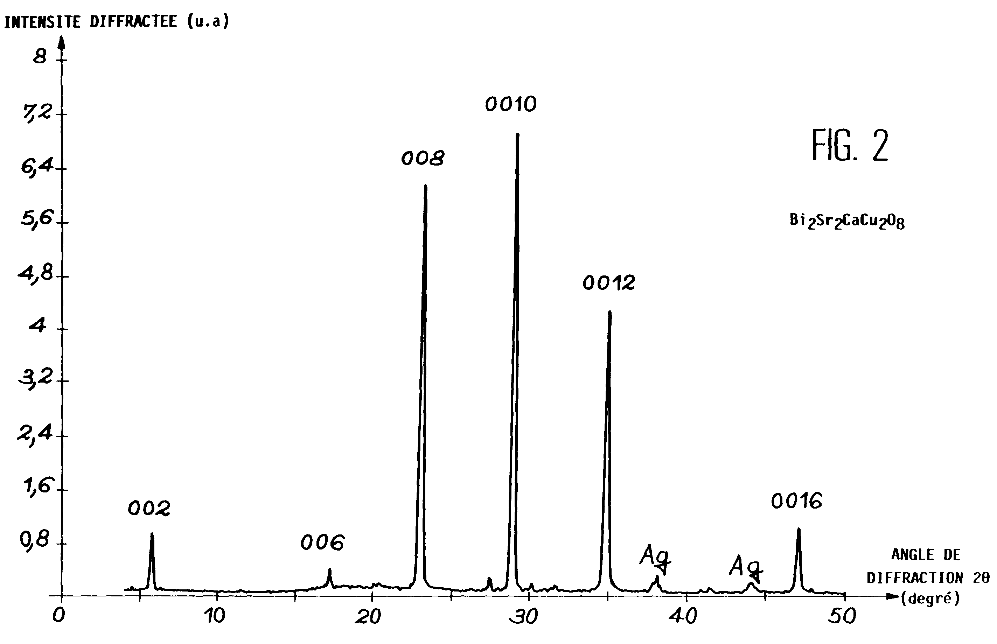

On étudie par ailleurs la couche par diffraction aux rayons X. Le diagramme de diffraction correspondant à la courbe 2 de la figure 1 est représenté sur la figure 2. On remarque ainsi que les divers grains des couches ont presque tous leurs plans (a, b) parallèles au plan du ruban, ce qui explique les très fortes densités de courant critique mesurées.

### Exemple 2 :2ème mode de préparation d'un ruban de Bi₂Sr₂CaCu₂O₈.

On suit le même mode opératoire que dans l'exemple 1 pour préparer un ruban en argent revêtu de ce matériau supraconducteur, mais on réalise le traitement thermique final en utilisant une température de 840°C pendant 12 heures pour le palier final au lieu de 800°C pendant 60 heures.

La courbe 2 de la figure 1 représente la résistivité du matériau obtenu en fonction de la température sous une densité de courant de 500 A/cm². On remarque que, dans ce cas, on observe la transition supraconductrice à une température légèrement inférieure qui est de 80K. La densité de courant critique à 77K est également de 10 à 15 000 A/cm².

Il est à noter que l'on obtient des résultats tout à fait similaires sur des couches plus épaisses préparées conformément à l'exemple 1 en répétant une première fois les étapes 2 à 6 de dépôt et de traitement thermique intermédiaire, une deuxième fois les étapes 2 à 5 et en utilisant un dépôt plus important de cuivre dans la première étape.

### Exemple 3 : Préparation du matériau supraconducteur YBa₂Cu₃O₇.

Pour réaliser ce matériau, on part d'une lame d'argent laminée de 50 µm d'épaisseur, de 20 mm de large et de 35 mm de longueur et on la soumet comme dans l'exemple 1 à un traitement préalable de dégraissage au trichloroéthane suivi d'un recuit sous air à 850°C pendant 15 minutes. On effectue ensuite les étapes suivantes.
1°/ dépôt d'une couche de cuivre représentant environ 7,5.10¹⁸ atomes de cuivre par cm² en opérant comme dans l'exemple 1.
2°/ dépôt d'une couche d'yttrium représentant environ 1,25.10¹⁸ atomes d'yttrium par cm² en utilisant comme bain d'électrolyse une solution à 0,1 mole/l de nitrate d'yttrium dans le DMSO et en plaçant la lame d'argent entre deux contre-électrodes de platine avec un courant total régulé à 180 mA. On élimine ensuite l'électrolyte résiduelle.
3°/ recuit de l'ensemble sous air à 850°C pendant 2 minutes
4°/ dépôt d'une couche de baryum représentant 2,5 10¹⁸ atomes de baryum par cm² à partir d'une solution à 0,1 mole/l de chlorure de baryum dans le mélange DMSO et AN(1/6 en volume), en utilisant un courant total régulé à 180 mA et deux contre-électrodes en platine, suivi d'une élimination des dernières traces de solution.
5°/ recuit de l'ensemble sous air à 850°C pendant 2 minutes,
6°/ répétition des étapes 2 à 4, et
7°/ traitement thermique final sous oxygène purifié comportant successivement : une montée rapide en température à 300°C/h jusqu'à 920°C, un palier de 15 h à cette température, un refroidissement à une vitesse de 1°C/min jusqu'à 450°C, un second palier de 2 h à cette dernière température et enfin un refroidissement à 1°C/h jusqu'à la température ambiante.

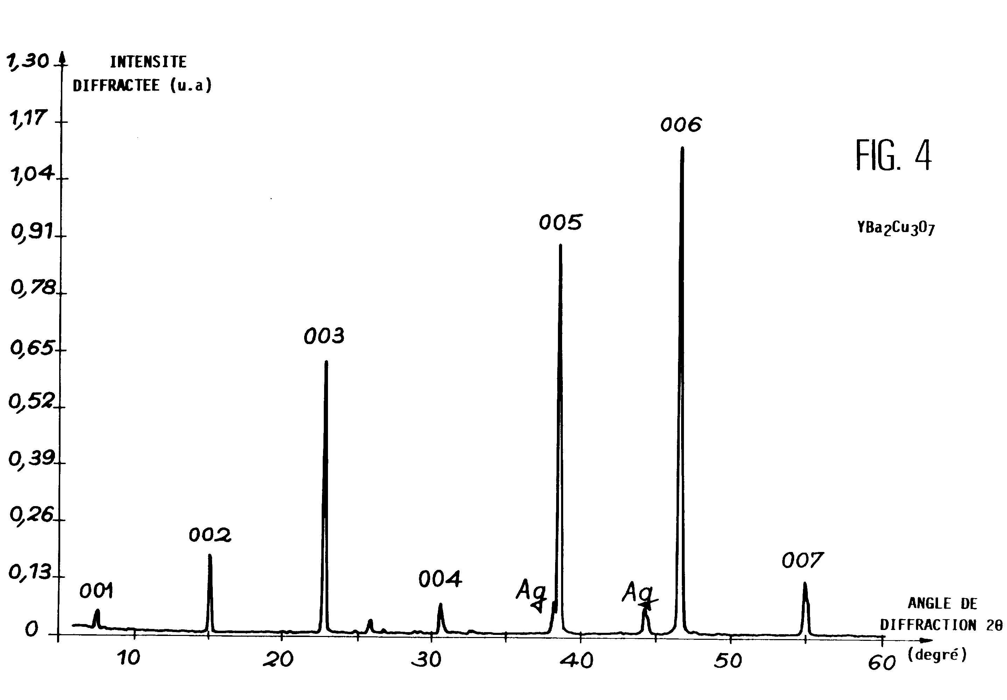

On détermine comme dans l'exemple 1 les variations de résistivité de la couche de YBaCuO en fonction de la température, sous une densité de courant de 500 A/cm². Les résultats obtenus sont représentés sur la figure 3 qui illustre les variations de la résistivité ρ(T)/ρ(l10) en fonction de la température (en K).

Sur cette figure, on remarque que la transition supraconductrice est étroite et correspond à une température critique sous courant faible de 86 à 90 K. La densité de courant critique à 77 K est comprise entre.2 000 et 5 000 A/cm².

La figure 4 représente le diagramme de diffraction X de la couche obtenue. On voit sur cette figure que les divers grains de la couche ont presque tous leurs plans (a, b) parallèles au ruban.

En revanche, la microstructure de cette couche diffère notablement de celle de l'exemple 1. En effet, les couches de Bi₂Sr₂CaCu₂O₈ sont constituéees de plusieurs épaisseurs de grains extrêmement plats, tandis que la couche de YBaCuO en comporte moins ; de plus, dans la couche de Bi₂Sr₂CaCu₂O₈, l'empilement des grains forme des terrasses à angles relativement vifs, couvrant toute la surface du substrat, tandis que dans l'YBaCuO, les grains sont plus arrondis et si fortement gravés au niveau des joints que l'argent du substrat apparaît aux jonctions triples.

Toutefois, l'utilisation de substrats à point de fusion plus élevé que celui de l'argent, devrait permettre de réaliser le traitement thermique final à une température supérieure pour fondre le YBaCuO et obtenir par solidification lente des courants critiques beaucoup plus élevés. De même, l'emploi d'un substrat ayant un coefficient de dilatation linéaire plus proche de celui de l'YBaCuO que l'argent, devrait éliminer la fissuration et augmenter la densité de courant critique.

Si l'on compare les résultats obtenus dans ces exemples à ceux obtenus dans le document US-A-5 162 295, on remarque que les transitions résistives sont plus étroites avec le procédé de l'invention (17 à 90 K dans le cas du brevet américain contre 86 à 90 K dans l'invention) et que les densités de courant critique sont beaucoup plus élevées dans l'invention : L'YBaCuO préparé selon le brevet américain n'est pas supraconducteur à 77K, alors que celui qui est préparé selon l'invention présente à cette même température, une densité de courant critique d'environ 5000 A/cm².

Le procédé de l'invention est donc très intéressant, car il permet d'améliorer de façon importante les performances du matériau supraconducteur par rapport au procédé du brevet US-A-5 162 295. Par ailleurs, il peut être mis en oeuvre pour obtenir des éléments supraconducteurs de forme variée, en particulier des éléments composites, des circuits électroniques, des rubans, des fils,des filaments, etc. De plus, le procédé peut être mis en oeuvre de façon à comporter des étapes complémentaires de dépôt d'une ou plusieurs couches destinées à la protection, à l'isolement, au renforcement ou encore à la thermalisation du matériau supraconducteur.

## Revendications

1. Procédé de préparation d'un matériau supraconducteur du type oxyde mixte, ledit oxyde mixte comportant p éléments métalliques, caractérisé en ce qu'il comprend les étapes suivantes :
a) déposer par électrolyse sur un substrat conducteur des couches successives des p éléments métalliques, chaque couche renfermant un seul élément et ayant une épaisseur telle qu'elle ne se détache pas du substrat ou de la couche précédemment déposée, et l'ordre des couches étant tel que les éléments susceptibles de réagir avec le substrat soient séparés de celui-ci par au moins une couche d'un autre élément, et effectuer, après le dépôt d'au moins l'une des couches, un traitement thermique intermédiaire d'oxydation-réaction pour fixer l'élément de cette couche avant de déposer la couche suivante,
b) répéter éventuellement une ou plusieurs fois au moins certaines opérations de dépôt électrolytique et de traitement thermique intermédiaire de l'étape a) pour obtenir l'épaisseur de matériau supraconducteur désirée, et
c) soumettre ensuite l'ensemble des couches à un traitement thermique final d'oxydation à une température suffisante pour former l'oxyde mixte supraconducteur.

2. Procédé selon la revendication 1, caractérisé en ce qu'il comprend de plus une étape préalable de traitement du substrat en vue de faciliter l'accrochage de la première couche déposée sur celui-ci et/ou d'améliorer l'homogénéité de cette première couche.

3. Procédé selon la revendication 2, caractérisé en ce que le substrat étant un substrat métallique, le traitement préalable consiste à effectuer un dégraissage suivi d'un recuit à haute température.

4. Procédé selon l'une quelconque des revendications 1 à 3, caractérisé en ce que le substrat est en argent.

5. Procédé selon la revendication 4, caractérisé en ce que, dans ladite couche d'argent, sont dispersés des atomes d'un autre métal plus oxydable de façon à former lors du traitement thermique final une gaine composite renforcée par une dispersion fine d'oxyde très dur.

6. Procédé selon l'une quelconque des revendications 1 à 3, caractérisé en ce que le substrat est un matériau métallique oxydable, ce qui permet, lors du traitement d'oxydation, la formation d'une couche d'oxyde dudit métal qui isole électriquement le substrat métallique de la couche supraconductrice.

7. Procédé selon la revendication 1, caractérisé en ce que le traitement thermique intermédiaire d'oxydation-réaction est effectué sur les couches d'éléments métalliques susceptibles de former sur le substrat avec les éléments des couches déposées précédemment des oxydes suffisamment conducteurs pour que l'on puisse effectuer le dépôt de la couche suivante.

8. Procédé selon la revendication 1, caractérisé en ce que l'épaisseur de chaque couche est de 0,5 à 2µm.

9. Procédé selon la revendication 1, caractérisé en ce que l'épaisseur totale des couches déposées est de 2 à 20 µm.

10. Procédé selon l'une quelconque des revendications 1 à 9, caractérisé en ce que l'oxyde composite comporte au moins un métal alcalino-terreux et en ce que l'on effectue dans l'étape a) un traitement thermique intermédiaire d'oxydation-réaction après le dépôt de chaque couche de métal alcalino-terreux.

11. Procédé selon l'une quelconque des revendications 1 à 10, caractérisé en ce qu'il comprend une étape complémentaire d'usinage du produit obtenu avant ou après l'étape c) de traitement thermique final, en vue de le mettre sous la forme d'élément supraconducteur.

12. Procédé selon l'une quelconque des revendications 1 à 10, caractérisé en ce que dans l'étape a) on réalise le dépôt des couches selon un tracé voulu en vue de former sur le substrat un circuit de matériau supraconducteur.

13. Procédé selon l'une quelconque des revendications 1 à 10, caractérisé en ce qu'il comprend de plus une étape d'usinage des couches déposées sur le substrat afin d'éliminer ces couches sur certaines zones du substrat et de former sur celui-ci un circuit de matériau supraconducteur, avant ou après l'étape c) de traitement thermique final.

14. Procédé selon l'une quelconque des revendications 1 à 10, caractérisé en ce que le dépôt est effectué sur des substrats de forme complexe, tels que des tresses, des torsades, des feutres ou des mousses.

15. Procédé selon l'une quelconque des revendications 1 à 10, caractérisé en ce que les éléments produits, éventuellement assemblés sous forme de tresses ou de torsades, sont inclus dans une gaine appropriée, l'ensemble étant ensuite soumis à des traitements thermomécaniques.

16. Procédé selon l'une quelconque des revendications 1 à 12, caractérisé en ce qu'il comprend au moins une étape complémentaire de dépôt d'une couche métallique, ou d'une couche de substance destinée à la protection, à l'isolement, au renforcement, à l'amélioration des propriétés électriques et magnétiques, ou encore à la thermalisation du matériau supraconducteur.

17. Procédé selon l'une quelconque des revendications 1 à 16, caractérisé en ce que le matériau supraconducteur est un oxyde mixte du type YBaCuO, LaBaCuO, LaSrCuO, BiSrCaCuO ou TlBaCaCuO, HgBaCaCuO, AgBaCaCuO et tous leurs dérivés substitués.

## Patentansprüche

1. Verfahren zur Herstellung eines supraleitenden Materials vom Mischoxidtyp, wobei genanntes Mischoxid p metallische Elemente enthält, dadurch gekennzeichnet, daß es die folgenden Schritte umfaßt:
a) Abscheiden aufeinanderfolgender Schichten der p metallischen Elemente auf einem leitfähigen Substrat durch Elektrolyse, wobei jede Schicht ein einziges Element enthält und eine solche Dicke hat, daß sie sich von dem Substrat oder von der vorher abgeschiedenen Schicht nicht ablöst, und die Reihenfolge der Schichten derart ist, daß die Elemente, die imstande sind, mit dem Substrat zu reagieren, von diesem durch mindestens eine Schicht eines anderen Elements getrennt sind, und, nach Abscheidung mindestens einer der Schichten, Ausführen einer intermediären Wärmebehandlung zur Oxidation und Reaktion, um das Element dieser Schicht vor der Abscheidung der folgenden Schicht zu fixieren,
b) gegebenenfalls ein- oder mehrmaliges Wiederholen zumindest gewisser Operationen der elektrolytischen Abscheidung und der intermediären Wärmeehandlung des Schritts a), um die gewünschte Dicke des supraleitenden Materials zu erhalten, und
c) nachfolgendes Unterziehen der Gesamtheit der Schichten einer abschließenden Wärmebehandlung zur Oxidation bei einer Temperatur, die ausreicht, um das supraleitende Mischoxid zu bilden.

2. Verfahren nach Anspruch 1, dadurch gekennzeichnet, daß es ferner einen vorangehenden Schritt der Behandlung des Substrats mit dem Ziel umfaßt, die Haftung der ersten abgeschiedenen Schicht auf diesem Substrat zu fördern und/oder die Homogenität dieser ersten Schicht zu verbessern.

3. Verfahren nach Anspruch 2, dadurch gekennzeichnet, daß, wenn das Substrat ein metallisches Substrat ist, die vorangehende Behandlung in einer Entfettung, gefolgt von einer Wärmebehandlung bei hoher Temperatur, besteht.

4. Verfahren nach einem der Ansprüche 1 bis 3, dadurch gekennzeichnet, daß das Substrat aus Silber ist.

5. Verfahren nach Anspruch 4, dadurch gekennzeichnet, daß in genannter Silberschicht Atome eines anderen, leichter oxidierbaren Metalls dispergiert sind, so daß bei der abschließenden Wärmebehandlung eine zusammengesetzte Umhüllung gebildet wird, die durch eine feine Dispersion eines sehr harten Oxids verstärkt ist.

6. Verfahren nach einem der Ansprüche 1 bis 3, dadurch gekennzeichnet, daß das Substrat ein oxidierbares metallisches Material ist, was bei der Oxidationsbehandlung die Bildung einer Oxidschicht des genannten Metalls erlaubt, die das metallische Substrat von der supraleitenden Schicht elektrisch isoliert.

7. Verfahren nach Anspruch 1, dadurch gekennzeichnet, daß die intermediäre Wärmebehandlung zur Oxidation und Reaktion an den Schichten metallischer Elemente ausgeführt wird, die imstande sind, auf dem Substrat mit den Elementen der vorher abgeschiedenen Schichten Oxide zu bilden, die genügend leitfähig sind, daß man die Abscheidung der folgenden Schicht ausführen kann.

8. Verfahren nach Anspruch 1, dadurch gekennzeichnet, daß die Dicke jeder Schicht 0,5 bis 2 µm beträgt.

9. Verfahren nach Anspruch 1, dadurch gekennzeichnet, daß die Gesamtdicke der abgeschiedenen Schichten 2 bis 20 µm beträgt.

10. Verfahren nach einem der Ansprüche 1 bis 9, dadurch gekennzeichnet, daß das zusammengesetzte Oxid mindestens ein Erdalkalimetall enthält und daß man in Schritt a) nach der Abscheidung jeder Schicht von Erdalkalimetall eine intermediäre Wärmebehandlung zur Oxidation und Reaktion ausführt.

11. Verfahren nach einem der Ansprüche 1 bis 10, dadurch gekennzeichnet, daß es vor oder nach Schritt c) der abschließenden Wärmebehandlung einen ergänzenden Schritt der Bearbeitung des erhaltenen Produkts mit dem Ziel umfaßt, es in die Form eines supraleitenden Elements zu bringen.

12. Verfahren nach einem der Ansprüche 1 bis 10, dadurch gekennzeichnet, daß man in Schritt a) die Abscheidung der Schichten entsprechend einem vorgesehenen Grundriß mit dem Ziel ausführt, auf dem Substrat eine Schaltung von supraleitendem Material zu bilden.

13. Verfahren nach einem der Ansprüche 1 bis 10, dadurch gekennzeichnet, daß es ferner vor oder nach Schritt c) der abschließenden Wärmebehandlung einen Schritt der Bearbeitung der auf dem Substrat abgeschiedenen Schichten umfaßt, um diese Schichten in gewissen Bereichen des Substrats zu entfernen und auf dem Substrat eine Schaltung von supraleitendem Material zu bilden.

14. Verfahren nach einem der Ansprüche 1 bis 10, dadurch gekennzeichnet, daß die Abscheidung auf Substraten komplizierter Gestalt wie Geflechten, Verdrillungen, Filzen oder Schwämmen erfolgt.

15. Verfahren nach einem der Ansprüche 1 bis 10, dadurch gekennzeichnet, daß die hergestellten Elemente, die gegebenenfalls in Form von Geflechten oder Verdrillungen zusammengefügt sind, in eine geeignete Umhüllung eingeschlossen werden, wobei das Ganze anschließend thermomechanischen Behandlungen unterzogen wird.

16. Verfahren nach einem der Ansprüche 1 bis 12, dadurch gekennzeichnet, daß es mindestens einen ergänzenden Schritt der Abscheidung einer metallischen Schicht oder einer Schicht einer Substanz umfaßt, die zum Schutz, zur Isolierung, zur Verstärkung, zur Verbesserung der elektrischen und magnetischen Eigenschaften oder schließlich zur Thermalisierung des supraleitenden Materials bestimmt ist.

17. Verfahren nach einem der Ansprüche 1 bis 16, dadurch gekennzeichnet, daß das supraleitende Material ein Mischoxid vom Typ YBaCuO, LaBaCuO, LaSrCuO, BiSrCaCuO oder TiBaCaCuO, HgBaCaCuO, AgBaCaCuO und aller ihrer substituierten Derivate ist.

## Claims

1. Process for the preparation of a superconductor material of the mixed oxide type, said mixed oxide incorporating p metallic elements, characterized in that it comprises the following stages:
a) depositing by electrolysis on a conductive substrate successive layers of p metallic elements, each layer containing a single element and having a thickness such that it is not detached from the substrate or the previously deposited layer, and the order of the layers is such that the elements liable to react with the substrate are separated therefrom by at least one layer of another element, and performing, following the deposition of at least one of the layers, an intermediate, oxidation-reaction, heat treatment for fixing the element of said layer before depositing the following layer,
b) optionally repeating one or more times at least certain of the electrolytic deposition and intermediate heat treatment operations of stage a) to obtain the desired superconductor material thickness and
c) then subjecting all the layers to a final, oxidation, heat treatment at an adequate temperature for forming the mixed superconductor oxide.

2. Process according to claim 1, characterized in that it also comprises a prior substrate treatment stage with a view to the facilitating of the attachment of the first layer deposited thereon and/or for improving the homogeneity of said first layer.

3. Process according to claim 2, characterized in that, as the substrate is a metal substrate, the prior treatment consists of scouring, followed by high temperature annealing.

4. Process according to any one of the claims 1 to 3, characterized in that the substrate is of silver.

5. Process according to claim 4, characterized in that, in said silver layer are dispersed atoms of another, more oxidizable metal in such a way as to form during the final heat treatment a composite sheath reinforced by a fine dispersion of very hard oxide.

6. Process according to any one of the claims 1 to 3, characterized in that the substrate is an oxidizable metallic material which permits, during the oxidation treatment, the formation of an oxide layer of said metal electrically insulating the metallic substrate from the superconductor layer.

7. Process according to claim 1, characterized in that the intermediate, oxidation-reaction, heat treatment is performed on layers of metallic elements liable to form on the substrate with elements of the previously deposited layers oxides which are sufficiently conductive to permit the performance of the deposition of the following layer.

8. Process according to claim 1, characterized in that the thickness of each layer is 0.5 to 2 µm.

9. Process according to claim 1, characterized in that the total thickness of the deposited layers is 2 to 20 µm.

10. Process according to any one of the claims 1 to 9, characterized in that the composite oxide incorporates at least one alkaline earth metal and in that in stage a there is an intermediate, oxidation-reaction, heat treatment after the deposition of each alkaline earth metal layer.

11. Process according to any one of the claims 1 to 10, characterized in that it comprises a complimentary stage of machining the product obtained before of after the final heat treatment stage c), with a view to bringing it into the form of a superconductor element.

12. Process according to any one of the claims 1 to 10, characterized in that in stage a) deposition takes place of the layers in accordance with a desired line so as to form on the substrate a superconductor material circuit.

13. Process according to any one of the claims 1 to 10, characterized in that it also comprises a stage of machining layers deposited on the substrate in order to eliminate said layers over certain substrate areas and form on the substrate a superconductor material circuit before or after the final heat treatment stage c).

14. Process according to any one of the claims 1 to 10, characterized in that the deposit is made on substrates having a complex form, such as braids, twists, felts or foams.

15. Process according to any one of the claims 1 to 10, characterized in that the elements produced, optionally assembled in the form of braids or twists, are included in an appropriate sheath, the assembly then undergoing thermomechanical treatments.

16. Process according to any one of the claims 1 to 12, characterized in that it comprises at least one complimentary stage of depositing a metal layer, or a layer of a substance intended for the protection, insulation, reinforcement, improvement of the electrical and magnetic properties or the thermalization of the superconductor material.

17. Process according to any one of the claims 1 to 16, characterized in that the superconductor material is a mixed oxide of the type YBaCuO, LaBaCuO, LaSrCuO, BiSrCaCuO or TlBaCaCuO, HgBaCaCuO, AgBaCaCuO and all their substituted derivatives.
